# EUROPEAN PATENT APPLICATION

(11) **EP 2 894 953 A1**
(43) Date of publication of application: **15.07.2015**
(21) Application number: 12884029.5
(22) Date of filing: 10.09.2012
(51) Int. Cl.: H05K 3/46, H05K 3/00

(54) **EMBEDDED PRINTED CIRCUIT BOARD AND METHOD FOR MANUFACTURING SAME**

(71) Applicant: Meiko Electronics Co., Ltd., Ayase-shi, Kanagawa 252-1104 (JP)
(72) Inventor: MATSUMOTO, Tohru, Ayase-shi Kanagawa 252-1104 (JP); AOKI, Kentaro, Ayase-shi Kanagawa 252-1104 (JP); TODA, Mitsuaki, Ayase-shi Kanagawa 252-1104 (JP)
(74) Representative: Epping - Hermann - Fischer
(86) International application number: PCT/JP2012/073050
(87) International publication number: WO 2014/038083

(57) **Abstract**

The present invention provides a component-embedded substrate (1) formed by dividing a laminate which is formed by bonding a component (12) onto a conductive material (10) placed on a support (8); sequentially laminating an insulation material (18, 28) and a core substrate (20) each having a component avoiding hole (32) which avoids the component; and hot-pressing the laminate to allow the melted insulation material to flow into the component avoiding hole to thereby form an integrated laminate (2, 36), wherein the component-embedded substrate includes regulation means (16, 34, 32, 38) which limits the displacement of the core substrate slipping on the insulation material melted during the hot pressing.

## Description

### Technical Field

The present invention relates to a component-embedded substrate and a manufacturing method thereof, and more particularly to a component-embedded substrate formed by sequentially laminating an insulation material and a core substrate each having a component avoiding hole which avoids a component, and to a manufacturing method thereof.

### Background Art

This type of component-embedded substrate is formed by dividing a laminate in the manufacturing process. The laminate is formed by bonding a component with an adhesive onto a copper foil (conductive material) placed on a manufacturing panel (support), sequentially laminating a prepreg (insulation material) and a core substrate from above, and hot-pressing the laminate (e.g., see Patent Document 1). The prepreg and the core substrate have a preformed component avoiding hole for avoiding contact interference with the component when they are laminated from above. During hot pressing, as the resin melted from the prepreg flows into the component avoiding hole and cures, an integrated laminate is formed, and this laminate is divided into individual component-embedded substrates.

### Prior Art Document

### Patent Document

Patent Document 1: Japanese Patent Laid-Open No. 2010-27917

### Summary of the Invention

### Problems to be solved by the Invention

Prior to hot pressing after lamination, the prepreg and the core substrate are positioned and fixed with their peripheral edge parts thermally welded on the manufacturing panel. In order to allow the resin melted from the prepreg to flow smoothly between the components and spread to every corner of the component avoiding hole so as to fill the hole, typically a resin composed of a high resin content is used or layers of sheets of prepregs are used. If an inner layer material constituting the laminate has thus a high resin content, the thermal weld of the core substrate on the manufacturing panel comes off due to the high heat during hot pressing of the laminate, causing the core substrate to slip and move inside the inner layer material, which may result in the component avoiding hole of the displaced core substrate contacting and interfering with the component and damaging the component.

The present invention has been made on the basis of the above-described situation, and an object of the present invention is to provide a high-reliability, high-quality component-embedded substrate and a manufacturing method thereof by limiting the displacement of the core substrate slipping on the resin of the prepreg melted during hot pressing of the laminate, and thereby securely preventing the core substrate from contacting and interfering with the component as well as from damaging the component.

### Means for Solving the Problems

In order to achieve the above object, the present invention provides a component-embedded substrate formed by dividing a laminate which is formed by bonding a component onto a conductive material placed on a support; sequentially laminating an insulation material and a core substrate each having a component avoiding hole which avoids the component; and hot-pressing the laminate to allow the melted insulation material to flow into the component avoiding hole and to thereby form the integrated laminate, wherein the component-embedded substrate includes regulation means which limits the displacement of the core substrate slipping on the insulation material melted during hot pressing.

Specifically, the regulation means includes a convex regulation member bonded on the conductive material and a regulation member avoiding hole bored in the insulation material and the core substrate at a position avoiding the regulation member, and a first distance between the component and a wall part of the component avoiding hole is larger than a second distance between the regulation member and a wall part of the regulation member avoiding hole.

Alternatively, the regulation means may be a convex regulation member which is bonded on the conductive material and disposed inside the component avoiding hole. In this case, a first distance between the component and a wall part of the component avoiding hole is larger than a third distance between the regulation member and the wall part.

The height of the regulation member from the conductive material is preferably larger than the thickness of the insulation material and smaller than the thickness of the insulation material and the core substrate.

Where the regulation means includes the regulation member and the regulation member avoiding hole, the regulation member is preferably disposed on the outer peripheral edges of the laminate at a plurality of positions, and more preferably is disposed in the laminate between substrate regions in which the component-embedded substrates are to be disposed.

Where the regulation means is a regulation member disposed inside the component avoiding hole, the regulation member is preferably disposed inside the component avoiding hole at a plurality of positions.

Where the regulation means includes the regulation member and the regulation member avoiding hole, the regulation member is preferably disposed in the laminate in substrate regions in which the component-embedded substrates are to be disposed.

The present invention further provides a manufacturing method of a component-embedded substrate including the steps of: placing a conductive material on a support; bonding a component and a regulation member on the conductive material; forming a laminate by sequentially laminating an insulation material and a core substrate each having avoiding holes which avoid the component and the regulation member; integrating the laminate by hot-pressing the laminate to allow the melted insulation material to flow into the avoiding holes while regulating the displacement of the core substrate slipping on the melted insulation material by means of the regulation member engaging with the avoiding hole; and forming the component-embedded substrates by dividing the integrated laminate.

### Advantageous Effects of the Invention

According to the component-embedded substrate and the manufacturing method thereof of the present invention, it is possible to provide a high-reliability, high-quality component-embedded substrate by limiting the displacement of the core substrate slipping on the resin of the prepreg melted during hot pressing of the laminate, and thereby securely preventing the core substrate from contacting and interfering with the component as well as from damaging the component.

### Brief Description of the Drawings

FIG. 1 is a top view of a laminate constituting a component-embedded substrate according to a first embodiment of the present invention.
FIG. 2 is a partially cross-sectional view of the laminate of FIG. 1 along the line A-A.
FIG. 3 is a top view of the laminate when the core substrate of FIG. 1 slips and moves inside an inner layer material.
FIG. 4 is a partially cross-sectional view of the laminate of FIG. 3 along the line B-B.
FIG. 5 is a top view of a laminate constituting a component-embedded substrate according to a modified example of FIG. 1.
FIG. 6 is a top view of a laminate constituting a component-embedded substrate according to a second embodiment of the present invention.
FIG. 7 is a partially cross-sectional view of the laminate of FIG. 6 along the line C-C.
FIG. 8 is a top view of the laminate when the core substrate of FIG. 6 slips and moves inside an inner layer material.
FIG. 9 is a partially cross-sectional view of the laminate of FIG. 8 along the line D-D.

### Mode for Carrying out the Invention

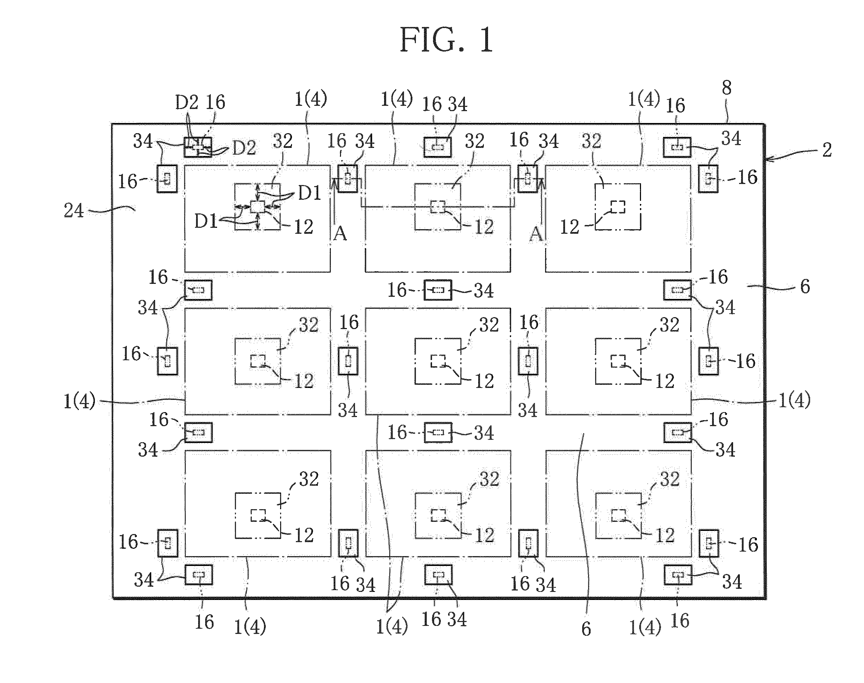

FIG. 1 is a top view of a laminate 2 constituting component-embedded substrates 1 according to a first embodiment of the present invention. The substrates 1 are formed by dividing the laminate 2 in the manufacturing process, and the laminate 2 has, for example, nine sections of substrate regions 4 which are to be individual substrates 1. A marginal region 6 is secured in the laminate 2 on its outer peripheral edges and between the substrates 1.

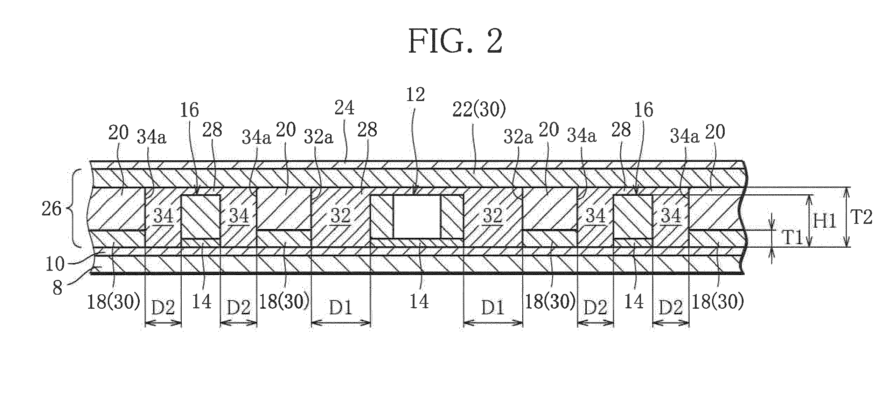

FIG. 2 is a partially cross-sectional view of the laminate 2 along the line A-A of FIG. 1. In the following, the configuration and the manufacturing process of the laminate 2 and the substrate 1 will be described.

First, a first layer of a copper foil (conductive material) 10 is placed on a manufacturing panel (support) 8 of the laminate 2. Next, an adhesive 14 is applied to the substrate region 4 of the copper foil 10 at a position at which an electric or electronic component 12 is to be disposed. The component 12 is placed on the adhesive 14, and the component 12 is bonded and fixed on the copper foil 10. For simplification of the illustration, only one component 12 is shown in each substrate region 4 in FIG. 1 and FIG. 2.

Here, in this embodiment, the adhesive 14 is applied to the marginal region 6 of the copper foil 10 at a predetermined position to be described later. A convex regulation member (regulation means) 16 to be described later is placed on the adhesive 14, and the regulation member 16 is bonded and fixed on the copper foil 10.

Next, a first layer of prepreg (insulation material) 18, a core substrate 20, a second layer of prepreg 22, and a second layer of copper foil 24 are sequentially laminated from above the component 12 and the regulation member 16.

Next, the peripheral edge part of the prepregs 18, 22 and the core substrate 20 is thermally welded onto the manufacturing panel 8 to position and fix an inner layer material 26 of the laminate 2, which includes the prepregs 18, 22, and the core substrate 20, on the manufacturing panel 8.

Next, the laminate 2 thus formed is hot-pressed and a predetermined pressure is applied to the laminate 2 in the vertical direction at a predetermined temperature.

The prepregs 18, 22 are sheet materials obtained by impregnating a base material 30 such as carbon fiber with a thermosetting resin (insulation material) 28 such as an epoxy resin and semi-curing the resin. When heated by hot pressing described above, the impregnating resin temporarily decreases in density, melting and flowing out of the base material 30, and when further heated, the resin having flowed out cures. The core substrate 20 is a resin plate material and not melted by the heat of hot pressing.

When the inner layer material 26 containing such prepregs 18, 22 is hot-pressed, the resin 28 melts from the prepregs 18, 22 and flows between the copper foils 10, 24 and is cured and bonded to the copper foils 10, 24, so that the laminate 2 integrated through the resin 28 is formed.

The prepreg 18 and the core substrate 20 each have preformed component avoiding hole 32 and regulation member avoiding hole (regulation means) 34 for avoiding contact interference with the component 12 and for avoiding contact interference with the regulation member 16, respectively, when they are laminated from above. These avoiding holes 32, 34 are filled as the resin 28 melted from the prepregs 18, 22 during hot pressing of the laminate 2 flows into the holes and cures.

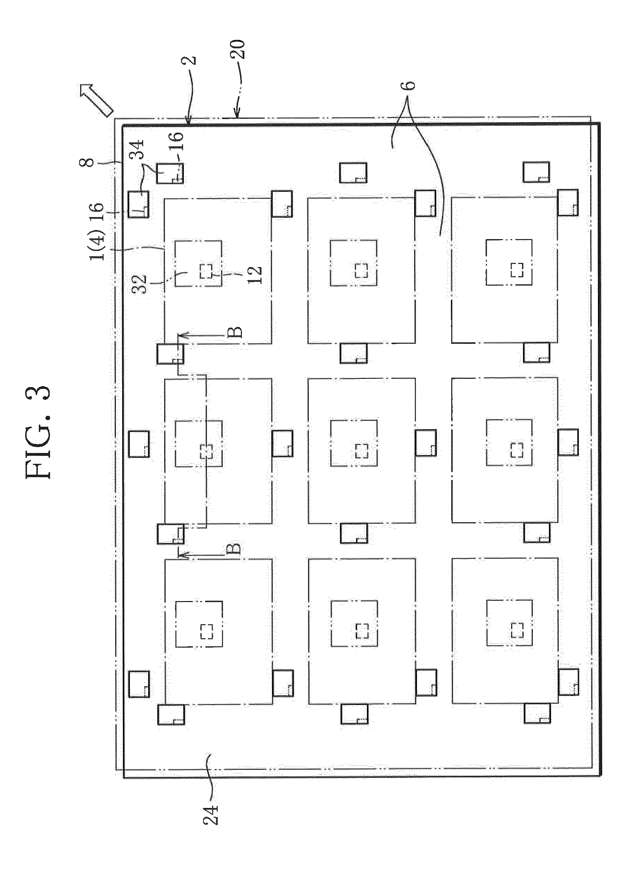

FIG. 3 is a top view of the laminate 2 when the core substrate 20 slips and moves inside the inner layer material 26 during hot pressing of the laminate 2. Such a slip phenomenon is likely to occur when the inner layer material 26 has a high content of the resin 28, and involves the thermal weld of the core substrate 20 on the manufacturing panel 8 coming off due to the high heat during hot pressing of the laminate 2, causing only the core substrate 20 to slip and move inside the inner layer material 26. In the case shown in FIG. 3, a displacement due to a slip of the core substrate 20 occurs in an oblique direction indicated by the arrow.

Here, in the state shown in FIG. 1 and FIG. 2 before the slip phenomenon occurs, a distance (first distance) D1 between the component 12 and a wall part 32a of the component avoiding hole 32 is set to be larger than a distance (second distance) D2 between the regulation member 16 and a wall part 34a of the regulation member avoiding hole 34. In this embodiment, the value of the distance D1 (e.g., 150 µm to 350 µm, preferably 200 µm) is equal from the four sides of the component 12 which is rectangular in top view, and the value of the distance D2 (e.g., 100 µm to 250 µm, preferably 150 µm) is also equal from the four sides of the regulation member 16 which is rectangular in top view. In other words, the component 12 is disposed roughly at the center in planar view of the component avoiding hole 32, and the regulation member 16 is also disposed roughly at the center in planar view of the regulation member avoiding hole 34.

A height H1 of the regulation member 16 from the copper foil 10 is larger than a thickness T1 of the prepreg 18 and smaller than a thickness T2 of the prepreg 18 and the core substrate 20 combined, and the regulation member 16 has a height almost equal to that of the component 12.

The pairs of regulation member 16 and regulation member avoiding hole 34 of this embodiment are disposed in the marginal region 6 of the laminate 2, and more particularly, are disposed in the marginal region 6 on the outer peripheral edges of the laminate 2 at positions facing the substrate regions 4, and in the marginal region 6 at positions between the substrate regions 4.

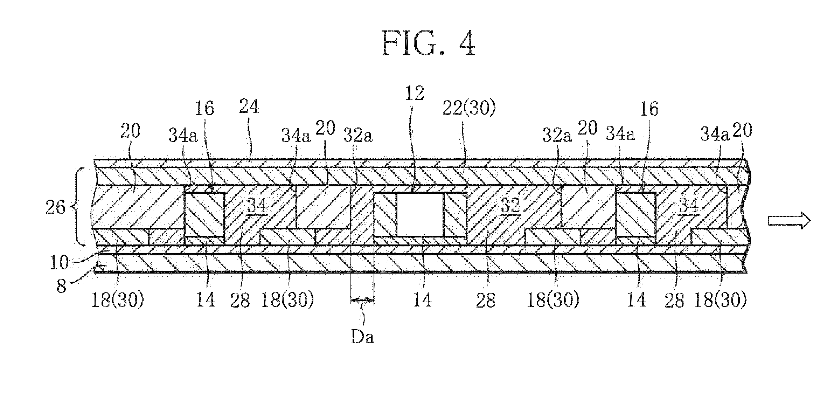

FIG. 4 is a partially cross-sectional view of the laminate 2 along the line B-B of FIG. 3. When the core substrate 20 slips inside the inner layer material 26 in the arrow direction shown in FIG. 3 and FIG. 4 during hot pressing of the laminate 2, the wall part 34a of the regulation member avoiding hole 34 comes into contact with the regulation member 16, so that the core substrate 20 stops moving at a distance Da short of coming into contact with the component 12 and a further displacement of the core substrate 20 is limited. The distance Da is a value obtained by subtracting the distance D2 from the distance D1.

As has been described, according to the component-embedded substrate 1 of this embodiment, the provision of the pairs of regulation member 16 and regulation member avoiding hole 34 makes it possible to limit the displacement of the core substrate 20 slipping on the resin 28 of the prepregs 18, 22 melted during hot pressing of the laminate 2, and to thereby securely prevent the core substrate 20 from contacting and interfering with the component 12 as well as from damaging the component 12. Thus, the high-reliability, high-quality component-embedded substrate 1 can be provided.

Specifically, since the distance D1 between the component 12 and the wall part 32a of the component avoiding hole 32 is larger than the distance D2 between the regulation member 16 and the wall part 34a of the regulation member avoiding hole 34, it is possible, when the core substrate 20 slips inside the inner layer material 26 during hot pressing of the laminate 2, to securely bring the wall parts 34a of the regulation member avoiding holes 34 into contact with the regulation members 16 before the core substrate 20 comes into contact with the component 12, and to stop further movement of the core substrate 20. Thus, the core substrate 20 can be prevented from contacting and interfering with the component 12 as well as from damaging the component 12 with a simple configuration.

Since the height H1 of the regulation member 16 from the copper foil 10 is larger than the thickness T1 of the prepreg 18 and smaller than the thickness T2 of the prepreg 18 and the core substrate 20 combined, it is possible, without blocking the flow of the resin 28 into the regulation member avoiding holes 34, to secure the rigidity of the laminate 2 and the substrate 1 after curing of the resin 28 while preventing damage to the component 12.

Since the pairs of regulation member 16 and regulation member avoiding hole 34 are disposed in the marginal region 6 on the outer peripheral edges of the laminate 2 at a plurality of positions facing the substrate regions 4 and in the marginal region 6 at positions between the substrate regions 4, it is possible, when the core substrate 20 slips inside the inner layer material 26 during hot pressing of the laminate 2, regardless of the direction of the slip, to securely bring the wall parts 34a of the regulation member avoiding holes 34 into contact with the regulation members 16 before the core substrate 20 comes into contact with the component 12, and to thereby stop further movement of the core substrate 20. Thus, the core substrate 20 can be more securely prevented from contacting and interfering with the component 12 as well as from damaging the component 12.

However, depending on the external dimensions of the substrate 1 to be manufactured, there may be no marginal region 6 wide enough to allow the regulation member 16 and the regulation member avoiding hole 34 to be disposed on the outer peripheral edges and between the substrate regions 4 of the laminate 2.

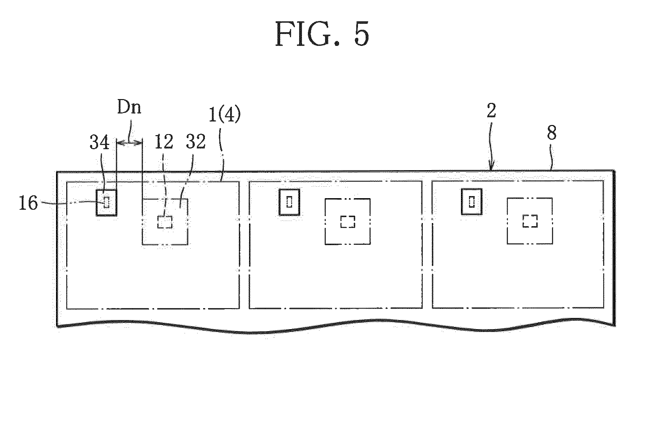

In this case, as shown in FIG. 5, the pair of regulation member 16 and regulation member avoiding hole 34 may be disposed inside the substrate region 4, namely, on the substrate 1 of the laminate 2. If in this way a distance Dn between the component avoiding hole 32 and the regulation member avoiding hole 34 becomes shorter than in the above-described first embodiment, the accuracy control of the positional relation between the component avoiding hole 32 and the regulation member avoiding hole 34 can be relaxed. That is, since the influence of an error in shape and position of the component avoiding hole 32 and the regulation member avoiding hole 34 can be mitigated, it is possible to more easily and securely bring the wall parts 32a into contact with regulation members 38 before the core substrate 20 comes into contact with the component 12, and thereby to more effectively enhance both the productivity and the quality of the component-embedded substrate 1.

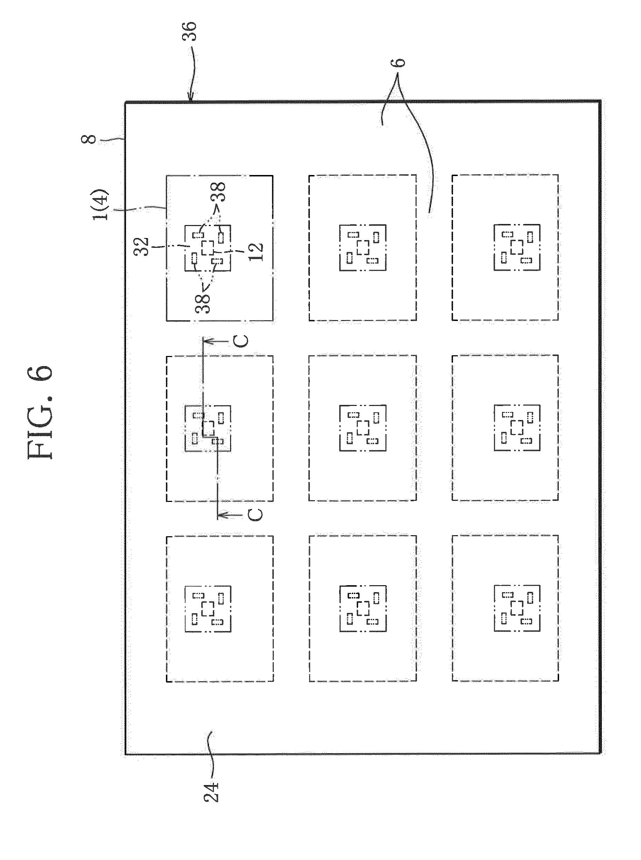

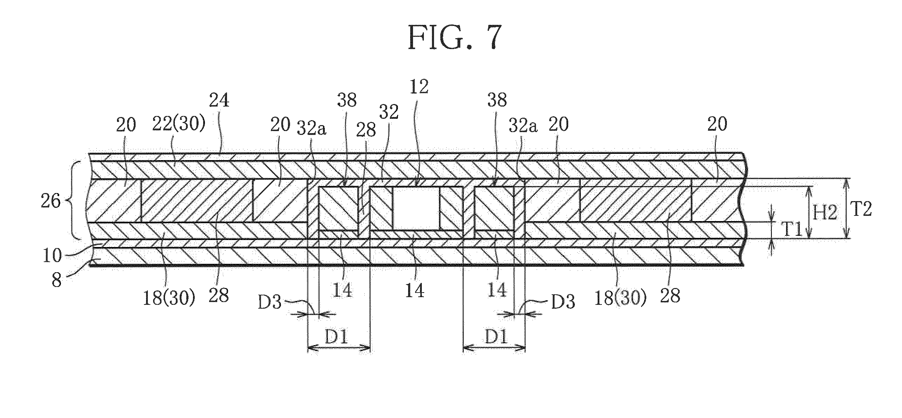

FIG. 6 is a top view of a laminate 36 constituting the component-embedded substrates 1 according to a second embodiment of the present invention, and FIG. 7 is a partially cross-sectional view of the laminate 36 along the line C-C of FIG. 6. The features overlapping with those of the first embodiment will be denoted by the same reference signs and the description thereof will be omitted.

In this embodiment, a regulation member (regulation means) 38 having a height similar to that of the regulation member 16 of the first embodiment is disposed in the component avoiding hole (regulation means) 32, and no regulation member avoiding hole 34 is provided.

In the state shown in FIG. 6 and FIG. 7 before the slip phenomenon occurs, the distance D1 between the component 12 and the wall part 32a of the component avoiding hole 32 is set to be larger than a distance (third distance) D3 between the regulation member 38 and the wall part 32a of the component avoiding hole 32. In this embodiment, the distance D1 is equal from the four sides of the component 12, which is rectangular in top view, to the wall part 32a of the component avoiding hole 32, and the distance D3 is also equal from the four sides of the regulation member 38, which is rectangular in top view, to the wall part 32a of the component avoiding hole 32.

The height H2 of the regulation member 38 from the copper foil 10 is larger than the thickness T1 of the prepreg 18 and smaller than the thickness T2 of the prepreg 18 and the core substrate 20 combined, and the regulation member 38 has a height almost equal to that of the component 12.

The regulation member 38 of this embodiment is disposed at four positions near the wall part 32a inside the component avoiding hole 32.

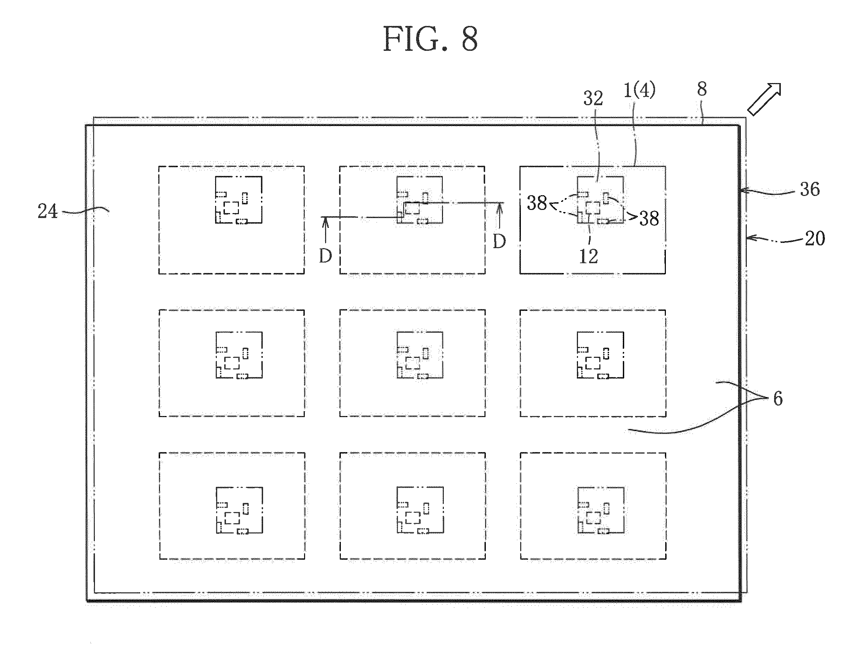

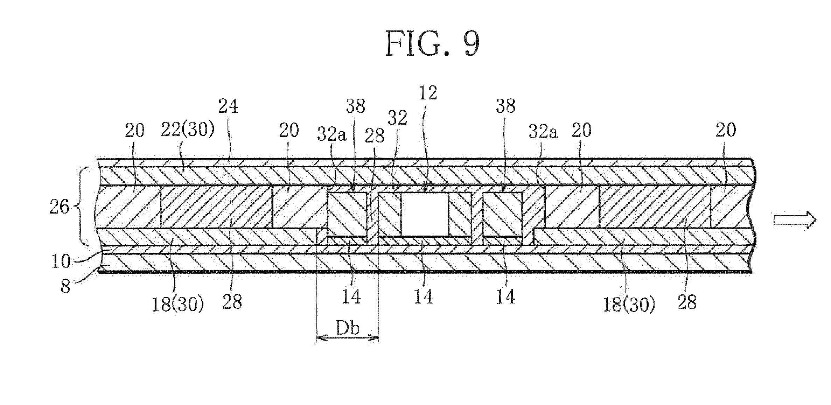

FIG. 8 is a top view of the laminate 36 when the core substrate 20 slips and moves in the arrow direction inside the inner layer material 26 during hot pressing of the laminate 36, and FIG. 9 is a partially cross-sectional view of the laminate 36 along the line D-D of FIG. 8.

When the core substrate 20 slips inside the inner layer material 26 in the arrow direction shown in FIG. 8 and FIG. 9 during hot pressing of the laminate 36, the wall parts 32a of the component avoiding holes 32 come into contact with the regulation members 38, so that the core substrate 20 stops moving at a distance Db short of coming into contact with the component 12 and further displacement of the core substrate 20 is limited. The distance Db is a value obtained by subtracting the distance D3 from the distance D1.

As has been described, according to the component-embedded substrate 1 of this embodiment, since the regulation member 38 is disposed inside the component avoiding hole 32, as with the first embodiment, it is possible to limit the displacement of the core substrate 20 slipping on the resin 28 of the prepregs 18, 22 melted during hot pressing of the laminate 36, and thereby to securely prevent the core substrate 20 from contacting and interfering with the component 12 as well as from damaging the component 12. Thus, the high-reliability, high-quality component-embedded substrate 1 can be provided.

Specifically, since the distance D1 between the component 12 and the wall part 32a of the component avoiding hole 32 is larger than the distance D3 between the regulation member 16 and the wall part 32a, as with the first embodiment, the core substrate 20 can be prevented from contacting and interfering with the component 12 as well as from damaging the component 12 with a simple configuration. Since the height H3 of the regulation member 38 from the copper foil 10 is larger than the thickness T1 of the prepreg 18 and smaller than the thickness T2 of the prepreg 18 and the core substrate 20 combined, it is possible, without blocking the flow of the resin 28 into the regulation member avoiding holes 34, to secure the rigidity of the laminate 2 and the substrate 1 after curing of the resin 28.

Since the regulation members 38 are disposed inside the component avoiding hole 32 at a plurality of positions near the wall part 32a, it is possible, when the core substrate 20 slips inside the inner layer material 26, regardless of the direction of the slip, to securely bring the wall parts 32a into contact with the regulation members 38 before the core substrate 20 comes into contact with the component 12, and thereby to stop further movement of the core substrate 20. Thus, the core substrate 20 can be more securely prevented from contacting and interfering with the component 12 as well as from damaging the component 12.

In particular, since this embodiment requires no regulation member avoiding hole 34 of the first embodiment, the configuration of the laminate 36 and the substrate 1 can be simplified. Moreover, since only the component avoiding hole 32 should be formed in the core substrate 20, the number of avoiding holes to be formed in the core substrate 20 can be reduced and the avoiding hole forming step can be simplified, which contributes to even higher productivity of the substrate 1.

Since only the component avoiding hole 32 should be formed in the core substrate 20, it is not necessary to control the accuracy of the positional relation between the component avoiding hole 32 and the regulation member avoiding hole 34. That is, since there is no need to consider the influence of an error in shape and position of the component avoiding hole 32 and the regulation member avoiding hole 34, the wall parts 32a can be easily and securely brought into contact with the regulation members 38 before the core substrate 20 comes into contact with the component 12, and both the productivity and quality of the component-embedded substrate 1 can be further enhanced.

The present invention is not limited to the above-described embodiments, but various modifications can be made to it.

For example, in the above-described embodiments, the component 12 and the regulation members 16, 38 are rectangular in top view, and the regulation members 16, 38 are disposed for each component 12 in all the directions perpendicular to the four sides of the component 12. However, the present invention is not limited to this example; the movement of the core substrate 20 in various directions can be effectively limited as long as the regulation member is disposed, if not for each component 12, at least on the outer peripheral edge of the laminate 2 at a plurality of positions or/and in the laminate 2 between the substrate regions 4 in the case of the first embodiment, and as long as they are disposed inside the component avoiding hole 32 at a plurality of positions near the wall part 32a in the case of the second embodiment.

Moreover, it is also acceptable that the value of the distance D1 is not equal from the four sides of the component 12 to the wall part 32a of the component avoiding hole 32; that the value of the distance D2 is not equal from the four sides of the regulation member 16 to the wall part 34a of the regulation member avoiding hole 34; that the value of the distance D3 is not equal between the regulation members 38 and the wall part 32a of the component avoiding hole 32; or that the component 12 and the regulation members 16, 38 are not rectangular in top view. In such cases, the movement of the core substrate 20 in various directions can be effectively limited by appropriately changing the positions or the numbers of the regulation members 16, 38 to be disposed.

### Explanation of Reference Signs

1 component-embedded substrate
2 laminate
4 substrate region
8 manufacturing panel (support)
10 copper foil (conductive material)
12 component
16 regulation member (regulation means)
18 prepreg (insulation material)
20 core substrate
28 resin (insulation material)
32 component avoiding hole (regulation means, avoiding hole)
32a wall part of component avoiding hole
34 regulation member avoiding hole (regulation means, avoiding hole)
34a wall part of regulation member avoiding hole
36 laminate
38 regulation member (regulation means)

## Claims

1. A component-embedded substrate formed by dividing a laminate which is formed by bonding a component onto a conductive material placed on a support; sequentially laminating an insulation material and a core substrate each having a component avoiding hole which avoids the component; and hot-pressing the laminate to allow the melted insulation material to flow into the component avoiding hole and to thereby form the integrated laminate, wherein
the component-embedded substrate includes regulation means which limits the displacement of the core substrate slipping on the insulation material melted during the hot pressing.

2. The component-embedded substrate according to claim 1, wherein
the regulation means includes:
a convex regulation member bonded on the conductive material; and
a regulation member avoiding hole which is bored in the insulation material and the core substrate at a position avoiding the regulation member, and
a first distance between the component and a wall part of the component avoiding hole is larger than a second distance between the regulation member and a wall part of the regulation member avoiding hole.

3. The component-embedded substrate according to claim 1,
wherein
the regulation means is a convex regulation member bonded on the conductive material and disposed inside the component avoiding hole, and
a first distance between the component and a wall part of the component avoiding hole is larger than a third distance between the regulation member and the wall part.

4. The component-embedded substrate according to claim 2 or 3, wherein the height of the regulation member from the conductive material is larger than the thickness of the insulation material and smaller than the thickness of the insulation material and the core substrate combined.

5. The component-embedded substrate according to claim 2, wherein the regulation member is disposed on outer peripheral edges of the laminate at a plurality of positions.

6. The component-embedded substrate according to claim 2 or 5, wherein the regulation member is disposed in the laminate between substrate regions in which the component-embedded substrates are to be disposed.

7. The component-embedded substrate according to claim 3, wherein the regulation member is disposed inside the component avoiding hole at a plurality of positions.

8. The component-embedded substrate according to claim 2, wherein the regulation member is disposed in the laminate in substrate regions in which the component-embedded substrates are to be disposed.

9. A manufacturing method of a component-embedded substrate, comprising the steps of:
placing a conductive material on a support;
bonding a component and a regulation member on the conductive material;
forming a laminate by sequentially laminating an insulation material and a core substrate each having avoiding holes which avoid the component and the regulation member;
integrating the laminate by hot-pressing the laminate to allow the melted insulation material to flow into the avoiding holes while regulating the displacement of the core substrate slipping on the melted insulation material by means of the regulation member engaging with the avoiding hole; and
forming the component-embedded substrates by dividing the integrated laminate.
